Europäisches Patentamt

**European Patent Office**

Office européen des brevets

(19)

(11) Numéro de publication: **0 009 677**
**B1**

(12) **FASCICULE DE BREVET EUROPEEN**

(45) Date de publication du fascicule de brevet: **28.10.81**

(51) Int. Cl.³: **H 01 L 21/306,**
**C 09 K 13/00**

(21) Numéro de dépôt: **79103406.9**

(22) Date de dépôt: **12.09.79**

(54) Solution quaternaire de décapage chimique du silicium et procédé de décapage utilisant une telle solution.

(30) Priorité: **11.10.78 US 950340**

(43) Date de publication de la demande:
**16.04.80 Bulletin 80/8**

(45) Mention de la délivrance du brevet:
**28.10.81 Bulletin 81/43**

(84) Etats Contractants Désignés:
**DE FR GB**

(56) Documents cités:
**US - A - 4 155 866**

**JOURNAL OF THE ELECTROCHEMICAL SOCIETY,**
**Vol. 125, Nr. 8, August 1978, Seite 351C**
**Princeton, U.S.A.**
**A. REISMAN et al.: "The Controlled Etching of**
**Silicon in Catalyzed Ethylene Diamine-**
**Pyrocatechol-Water Solutions"**

**JOURNAL OF THE ELECTROCHEMICAL SOCIETY,**
**Vol. 126, Nr. 8, August 1979, Seiten 1406—1415**
**Princeton, U.S.A.**
**A. REISMAN et al.: "The Controlled Etching of**
**Silicon in Catalyzed Ethylenediamine-**
**Pyrocatechol-Water Solutions"**

(73) Titulaire: **International Business Machines**
**Corporation**
**Armonk, N.Y. 10504 (US)**

(72) Inventeur: **Berkenblit, Melvin**
**2232 Ridge Street**
**Yorktown Heights New York 10598 (US)**
Inventeur: **Reisman, Arnold**
**2294 vanCortland Circle**
**Yorktown Heights New York 10598 (US)**

(74) Mandataire: **Colas, Alain**
**COMPAGNIE IBM FRANCE Département de**
**Propriété Industrielle**
**F-06610 - La Gaude (FR)**

Courier Press, Leamington Spa, England.

## Solution quaternaire de décapage chimique du silicium et procédé de décapage utilisant une telle solution

### Domaine technique

La présente invention concerne un procédé de décapage chimique du silicium ainsi qu'une composition quaternaire de décapage contenant, outre de l'éthylène-diamine, de l'eau et de la pyrocatéchine, une diazine en quantité supérieure à l'équivalent molaire de 5 g de pyrazine/litre d'éthylène-diamine.

### Etat de la technique antérieure

L'emploi d'un décapant comportant de l'eau, une amine et de la pyrocatéchine aux fins du décapage du silicium est bien connu. Cette composition est particulièrement utile car elle permet d'obtenir un décapage anisotrope. Dans leur article intitulé "A Water-Amine Complexing Agent System for Etching Silicon" paru dans la publication "J. Electrochem. Soc.", *114*, p. 965, (1967), R.M. Finne et D.L. Klein étudient des décapants constitués par différents mélanges d'eau, d'amine et d'un agent de complexation, et concluent qu'un tel décapant présente une anisotrophie satisfaisante dans le cas du silicium.

Par ailleurs, le décapant à base d'eau, d'amine et de pyrocatéchine décrit dans la publication "Industrial Research" p. 17, Août 1977, s'est révélé utile aux fins du décapage de rainures en forme de V dans des tranches de silicium découpées suivant un certain angle par rapport à leur orientation cristalline. Ce décapant convient particulièrement bien à la réalisation de mesas à flancs inclinés dans des dispositifs semi-conducteurs et à la formation de buses en silicium destinées à être employées dans des imprimantes du type à projection d'encre (cf. le brevet des E.U.A. N° 3 974 169). Pour pouvoir fabriquer de façon reproductible de tels éléments, il est indispensable de contrôler constamment la composition du bain de décapage. Par exemple, il est extrêment important de contrôler la vitesse de décapage obtenue afin que les géométries des microstructures à décaper puissent être maintenues de façon reproductible dans les tolérances désirées.

De même, il est important que la vitesse de décapage et, partant, la composition du bain ne varient pas lorsqu'on renouvelle le décapant.

Ainsi qu'on l'a observé (cf. le brevet des E.U.A. N° 4.155.866 qui correspond à l'EP - A - 0004872), des variations importantes et inexplicables de la vitesse de décapage du silicium ont été observées d'un lot d'amine, (c'est-à-dire d'éthylène-diamine), à l'autre, bien qu'une même quantité d'amine ait été utilisée dans chaque bain. De telles variations sont inadmissibles si l'on désire fabriquer des dispositifs identiques.

L'invention décrite dans le brevet précité permet de résoudre les incertitudes afférentes aux décapants ternaires de l'art antérieur grâce à l'emploi d'un procédé de contrôle de la vitesse de décapage relative à un décapant donné. En commandant la quantité des diazines spécifiques présentes dans le décapant, il devient en effet possible de maintenir l'uniformité des caractéristiques de ce dernier d'un lot à l'autre. Ce résultat est obtenu en ajoutant des diazines à différents lots d'éthylène-diamine de telle sorte que tous les lots possèdent une même quantité de diazine.

D'autre part, dans la gamme définie des concentrations de diazine, on peut modifier la vitesse de décapage sans avoir à modifier la température, étant donné qu'en faibles quantités, ces composés jouent le rôle de catalyseur. L'intensité de la catalyse et, partant, la vitesse de décapage sont fonction de la concentration du catalyseur.

Etant donné que différents lots d'éthylène-diamine peuvent contenir des traces de diazine, il peut y avoir lieu de procéder à un examen spectrophotométrique aux rayons ultra-violets, qui permettra, avec l'établissement de courbes de calibration de la vitesse de décapage, de contrôler attentivement la concentration de diazine.

Dans le brevet précité N° 4.155.866, on a démontré que la vitesse de décapage pouvait être contrôlée en ajoutant à la composition des quantités déterminées de diazine ou de dérivés de celle-ci. Si l'on dépasse ces quantités, on observe la formation d'un résidu indésirable sur le substrat qui fait l'objet du décapage. D'autre part, le décapage doit nécessairement être effectué, selon le procédé décrit, à une température comprise entre 100°C environ et 119°C environ, et par ailleurs la solution est sensible à l'oxygène.

### Exposé de l'invention

Selon la présente invention, une modification de la concentration des composants du décapant permet d'ajouter à celui-ci de la diazine ou des dérivés de celle-ci en quantité supérieure à l'équivalent molaire de 5g de pyrazine/litre d'éthylène-diamine. Cela permet d'obtenir des surfaces décapées dépourvues de résidu, des vitesses de décapage constantes qui sont relativement insensibles à la dégradation dûe à l'oxygène, et un décapage qui peut être effectué à une température comprise entre environ 20°C et 119°C. Deux solutions de décapage sont définies ci-après, qui permettent respectivement d'obtenir un décapage lent effectué à une température comprise entre environ 20°C et 119°C, et un décapage rapide effectué à une température comprise entre environ 100°C et 119°C.

La présente invention concerne un procédé de décapage du silicium monocristallin et polycristallin au moyen d'un décapant capable de résister à l'oxygène et permettant d'obtenir des surfaces dépourvues de résidu, ledit, procédé comportant les étapes suivantes:

a) préparation d'une solution de décapage comprenant environ de 700 à 800 ml d'éthylène-diamine, de 110 à 130 g de pyrocatéchine, de 40 à 100 ml d'eau, et une quantité de diazine correspondant environ à l'équivalent molaire de 5 à 10 g de pyrazine/litre d'éthylène-diamine, et

b) application de ladite solution de décapage audit silicium à une température comprise entre 20°C et 119°C environ et pendant un intervalle de temps suffisant pour réaliser la configuration de décapage désirée.

La présente invention concerne également une solution de décapage capable de résister à l'oxygène et permettant d'obtenir des surfaces dépourvues de résidu, solution comportant de 700 à 800 ml environ d'éthylène-diamine, de 110 à 130 g environ de pyrocatéchine, de 40 à 100 ml environ d'eau et une diazine dont la quantité correspond à l'équivalent molaire de 5 à 10 g de pyrazine/litre d'éthylène-diamine.

L'invention prévoit également une solution de décapage capable de résister à l'oxygène et qui permet d'obtenir des surfaces dépourvues de résidu, cette solution comportant de 700 ml à 800 ml environ d'éthylène-diamine, de 200 g à 250 g environ de pyrocatéchine, de 200 ml à 250 ml environ d'eau, et une diazine dont la quantité correspond à l'équivalent molaire de 5 g à 10 g de pyrazine/litre d'éthylène-diamine.

L'invention concerne en outre un procédé de décapage de silicium monocristallin et polycristallin au moyen de la solution ci-dessus, l'operation de décapage s'effectuant à une température approximativement comprise entre 100°C et 119°C.

L'un des objets de la présente invention est donc de fournir un procédé de décapage du silicium qui permet d'obtenir des surfaces dépourvues de résidu et qui fait appel à l'emploi d'un décapant capable de résister à l'oxygène.

Un autre objet de l'invention est de fournir des solutions de décapage du silicium qui permettent d'obtenir un décapage lent ou rapide, lesdites solutions étant stabilisées à l'oxygène et ne laissant aucun résidu sur la surface décapée.

Un autre objet de l'invention est de fournir un procéde de décapage du silicium et une solution de décapage susceptible d'être utilisée à des températures approximativement comprises entre 20°C et 119°C.

D'autres objets, caractéristiques et avantages de la présente invention ressortiront mieux de l'exposé qui suit, fait en référence aux dessins annexés à ce texte, qui représentent un mode de réalisation préféré de celle-ci.

### Brève description des figures

La Figure 1 représente les variations de la vitesse de décapage de surfaces de silicium à orientation cristalline (100) en fonction de la quantité d'eau contenue dans les bains de décapage lent de la présente invention, et ce, à différentes températures.

La Figure 2 illustre la relation qui existe entre la vitesse de décapage et la température des bains de décapage lent de l'invention, pour deux proportions d'eau différentes.

La Figure 3 représente la variation de la vitesse de décapage en fonction de la température pour un bain de décapage lent, dans le cas où le bain a été exposé à l'oxygène pendant quatre heures, et dans le cas où il n'a pas été exposé à l'oxygène.

### Mode de réalisations préférées Postérieurement à la découverte des effets de la diazine et des ses dérivés sur la vitesse de décapage obtenue avec des solutions de décapage ternaires constituées, de façon classique, par de l'éthylène-diamine, de la pyrocatéchine et de l'eau, la demanderesse a cherché à obtenir des solutions quaternaires comportant ces trois éléments et contenant en outre une diazine ou des dérivés de celle-ci, ces solutions quaternaires devant être capables de résister aux effets de l'oxygène et devant permettre d'obtenir des surfaces dépourvues de résidu. Il a été initialement observé que, lorsque la quantité de diazine dépassait une quantité molaire équivalant à 4 ou 5 g de pyrazine/litre d'éthylène-diamine, un résidu avait tendance à se former sur la surface décapée du silicium. Il a été ultérieurement observé qu'en augmentant la quantité de diazine, le décapant résistait davantage aux effets de l'oxygène, c'est-à-dire que le décapant pouvait être exposé à l'air sans que cela se traduise par une modification importante de la vitesse de décapage.

Des expériences ultérieurement effectuées ont permis de constater qu'en augmentant la concentration de la pyrocatéchine tout en augmentant la quantité de diazine de telle sorte qu'elle corresponde à l'équivalent molaire de 5 à 10 g environ de pyrazine/litre d'éthylène-diamine, on obtenait un décapant qui avait une action rapide, permettait d'obtenir des surfaces sans résidue et était insensible aux effets de l'oxygène dans la gamme de températures comprise entre 100°C et 119°C environ. Par exemple, le tableau ci-après montre les effets de diverses concentrations de la diazine 1,4 (pyrazine), en g/l d'éthylène-diamine, sur la vitesse de décapage lors d'une exposition à l'oxygène. On a fait barboter de l'oxygène dans la solution de décapage à raison de 50 cm³/min à une température constante de 115°C. Ainsi qu'on peut le constater, alors que la vitesse de décapage obtenue dans le cas de la solution ne comportant pas de diazine augmente de 27% après exposition à l'oxygène pendant une heure, les vitesses de décapage obtenues dans le cas des solutions contenant une quantité de 1,4 diazine correspondant à l'équivalent molaire de 6 g/l d'éthylène-diamine sont pratiquement indentiques, que ces solutions aient ou non été exposées à de l'oxygène pendant une heure.

TABLEAU

| Concentration de la pyrazine dans l'éthy-lène-diamine (g/l) | Temp. de Decapage (°C) | Durée de l'exposition à l'oxygène (h) | Vitesse de décapage ($\mu$m/h) |
|---|---|---|---|
| 0 | 115 | 0 | 27 |
| 0 | 115 | 1 | 34 |
| 2 | 115 | 0 | 68 |
| 2 | 115 | 1 | 70 |
| 6 | 115 | 0 | 81 |
| (décapage rapide) | | | |
| 6 | 115 | 1 | 81 |

A la suite des expériences ci-dessus, on a constaté qu'une solution de décapage rapide capable de résister à l'oxygène et permettant d'obtenir des surfaces sans résidu pouvait être préparée à partir d'un mélange composé de 700 ml à 800 ml environ d'éthylène-diamine, de 200 g à 250 g environ de pyrocatéchine, de 200 ml à 250 ml environ d'eau, et d'une diazine ou d'un dérivé de celle-ci selon une quantité correspondant approximativement à l'équivalent molaire de 5 à 10 g de pyrazine/litre d'ethy-lène-diamine. Cette solution de décapage rapide est utilisable dans la gamme de températures allant de 100°C à 119°C environ. Au-dessous de 100°C cette solution perd son immunité à la formation de résidus.

Une solution de décapage rapide préférée se compose de 750 ml d'éthylène-diamine, de 240 g de pyrocatéchine, de 240 ml d'eau et de 6 g de pyrazine par litre d'éthylène-diamine. La vitesse de décapage du silicium d'orientation cristalline (100) que cette solution permet d'obtenir à 115°C est d'environ 81 $\mu$m/h.

On a d'autre part cherché à obtenir une solution de décapage ne provoquant pas la formation de résidus et capable de résister aux effets de l'oxygène, pouvant être utilisée à des températures comprises entre la température ambiante et la température d'ébullition de la solution, et offrant une vitesse de décapage plus lente que celle précédemment indiquée afin de pouvoir être appliquée au décapage de films minces ou de structures de très faible épaisseur. On a constaté que ce résultat pouvait être obtenu en diminuant la quantité d'eau contenue dans la bain ci-dessus comportant une quantité de diazine supérieure à l'équivalent molaire de 4 à 5 g de pyrazine/litre d'éthylène-diamine. Des expériences ont été effectuées au cours desquelles la quantité de diazine, c'est-à-dire de pyrazine, a été maintenue à une valeur constante de 6 g/l d'éthylène-diamine cependant que la quantité d'éthylène-diamine était maintenue à 750 ml pour une quantité de 120 g de pyrocatéchine, tout en faisant varier la quantité d'eau contenue dans le bain.

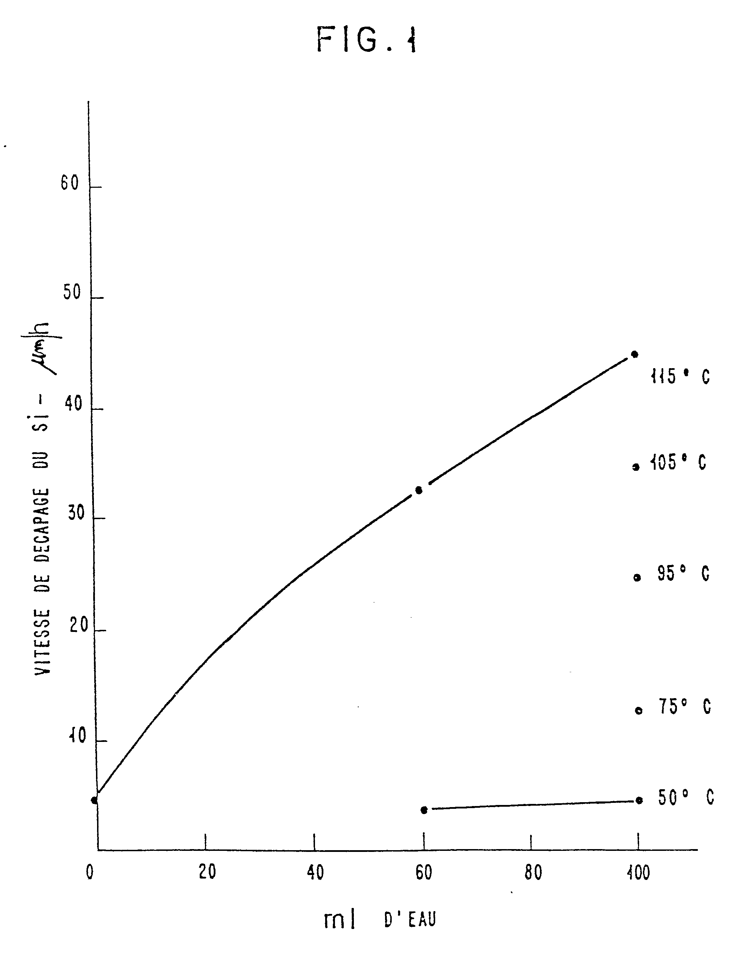

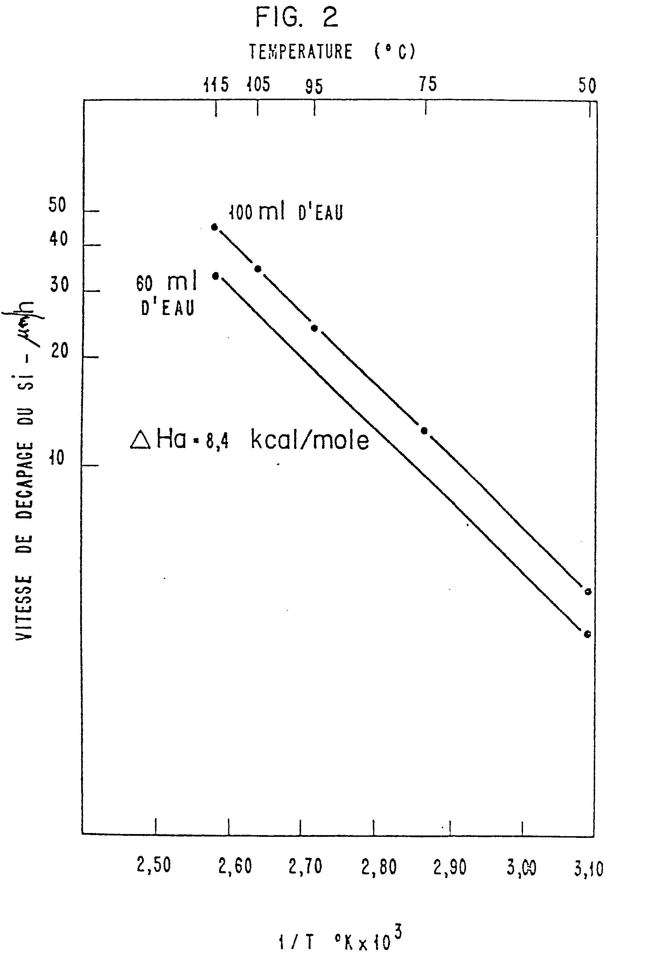

La Figure 1 montre les variations de la vitesse de décapage de surfaces de silicium d'orientation (100) soumises à de telles solutions, en fonction de la quantité d'eau contenue dans le bain, et ce, pour différentes températures. La Figure 2 montre la relation qui existe entre la température et la vitesse de décapage dans le cas de bains contenant des proportions d'eau différentes. Il ressort des Figures 1 et 2, que lorsqu'on diminue la quantité d'eau du bain, la vitesse de décapage diminue, et que toute diminution de la quantité d'eau a pour effet de diminuer la tendance à la formation de résidus. On peut également constater que l'énergie d'activation de décapage ($\Delta H_a$) reste constante en dépit des variations de la quantité d'eau contenue dans le bain. Ainsi, dans le cas d'un bain préféré contenant 6 g de pyrazine/litre d'éthylène-diamine, 450 ml d'éthylène-diamine, 120 g de pyrocatéchine et 100 ml d'eau, ceci correspondant à un décapage lent, aucune formation de résidu n'a été observée jusqu'à 50°C après décapage pendant une heure de tranches de silicium d'orientation (100). De même, aucune formation de résidu n'a été observée même en diminuant la quantité d'eau jusqu'à 60 ml. Cependant, des résidus ont été observés à 50°C dans le cas d'un bain contenant 120 ml d'eau et des quantités d'éthylène-diamine, de pyrocatéchine et de pyrazine identiques à celles précédemment mentionnées.

A partir de la Figure 2, on peut établir une équation permettant de déterminer les vitesses de décapage qui pourraient être obtenues à des températures inférieures à 50°C, par exemple:

$$\log R = \frac{-8,4 \times 10^3}{4,576T} + 6,375$$

où R = vitesse de décapage en $\mu$m/h et
T = température de décapage en °K.

Par exemple, si l'on veut déterminer la vitesse de décapage à 20°C,

$$T = 273,2 + 20,0 = 293,2 \, K°$$

$$\log R = \frac{-8,4 \times 10^3}{4,576 \times 293,2} + 6,375$$

$$\log R = \frac{-8,4 \times 10^3}{1342} + 6,375$$

$$= -6,25 + 6,375$$

$$\log R = 0,116$$

$$R = 1,3 \mu m/h.$$

La réalisation d'un décapant utilisable à de basses températures a essentiellement pour objet une diminution de la vitesse de décapage du silicium de manière à permettre, dans les meilleures conditions possibles, le décapage de films minces (de l'ordre de 1$\mu$m ou moins) de silicium monocristallin ou polycristallin, sans que cela se traduise par la formation de résidus. Pour pouvoir commander le décapage de façon appropriée, il est nécessaire de diminuer la vitesse de décapage de telle sorte que la durée de l'opération de décapage soit de l'ordre de 4 à 5 minutes au lieu de 20 à 30 secondes.

La solution dite de décapage lent permet d'obtenir un tel intervalle de temps dans le cas de films d'une épaisseur d'environ 0,4$\mu$ qui sont décapés à 50°C. Comme le montre la Figure 2, on peut faire varier la vitesse de décapage lent du silicium monocristallin d'orientation (100), d'environ 4,5$\mu$m/h à 45$\mu$m/h pour une gamme de températures allant de 50 à 115°C.

A 50°C, la solution préférée de décapage lent permet de décaper du silicium polycristallin à raison d'environ 6$\mu$m/h. Par ailleurs, cette solution est très résistante à l'exposition à l'air lorsqu'elle est utilisée à 50°C dans un becher ouvert. Dans les cas extrêmes, lorsqu'on fait barboter de l'oxygène pur directement dans la solution pendant une heure, on constate qu'il ne se produit qu'une très faible modification de la vitesse de décapage. Dans le cas d'une exposition prolongée à l'air (contact direct de l'air avec l'interface de la solution), la solution vire au rouge, puis au noir, mais la vitesse de décapage n'est pas affectée de façon importante.

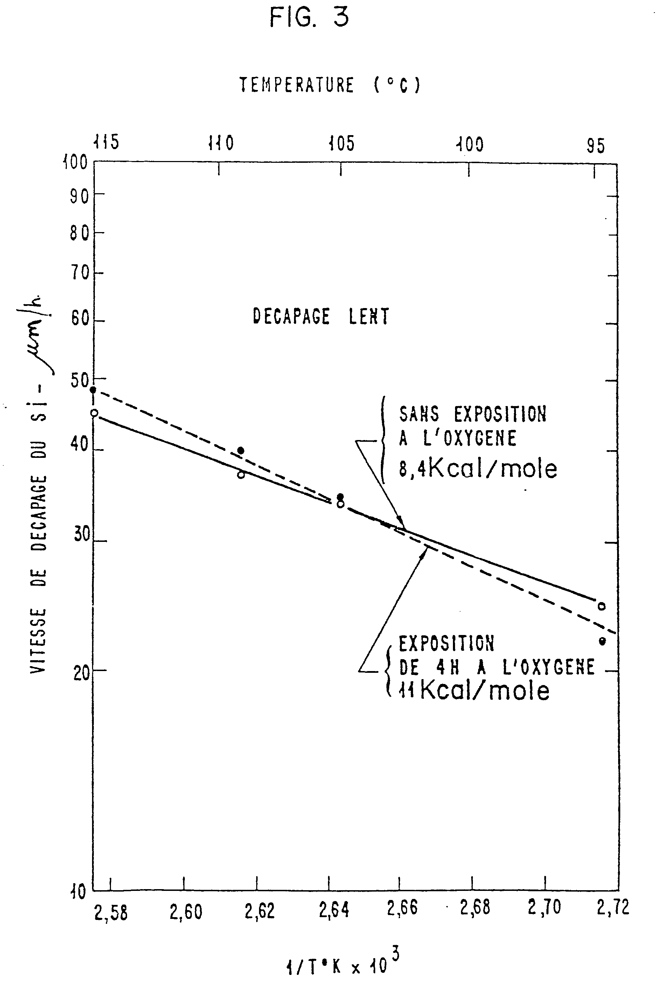

Il est intéressant de comparer les données afférentes à la température et à la vitesse de décapage dans le cas d'une solution de décapage lent traitée avec de l'oxygène pendant 4 heures, avec les données obtenues en l'absence d'un tel traitement (voir Figure 3). Ainsi qu'on peut le constater, le fait d'exposer la solution à de l'oxygène pur pendant un intervalle de temps aussi long a pour effet d'augmenter l'énergie d'activation de la réaction de décapage et de la ramener vers la valeur initialement observée lorsque la solution ne comporte pas de diazine. Le fait le plus intéressant est que les deux courbes se coupent à 150°C, ce qui signifie que si la solution de décapage est employée à cette dernière température, elle devrait pouvoir résister indéfiniment aux effets de l'oxygène, c'est-à-dire qu'elle serait essentiellement stable thermodynamiquement. A des températures plus basses ou plus élevées, la résistance aux effets de l'oxygène est, d'un point de vue pratique, une question cinétique. Aux températures les plus basses, où la vitesse de réaction de la solution à l'oxygène est lente, l'oxygène n'a pratiquement aucun effet, cependant qu'aux températures plus élevées, la vitesse de la réaction entre l'air contenant 20% d'oxygène, et la surface de la solution influe sur le décapage. Il est vraisemblable que des points de rencontre des courbes existent pour chacune des différentes quantités d'eau contenues dans la solution de décapage.

Aux températures égales ou inférieures à 75°C, le comportement représenté sur la Figure 3 est modifié: si l'on fait barboter de l'oxygène dans la solution de décapage lent à 75°C ou à 50°C pendant quatre heures, la vitesse de décapage à cette température devient nulle, mais si la solution est ensuite portée à une température égale ou supérieure à 95°C pendant quelques minutes, et si l'on mesure de nouveau la vitesse de décapage à une température quelconque comprise entre 52°C et 115°C, elle atteint de nouveau la valeur que l'on aurait constaté dans le cas d'une solution de décapage lent qui n'aurait pas été exposée à de l'oxygène. Ceci indique que lorsqu'on fait barboter de l'oxygène dans la solution à des températures inférieures à 95°C, le décapant devient inopérant, mais cet effet disparaît si l'on porte pendant quelques instants la température à 95°C ou à une valeur supérieure. D'un point de vue pratique, comme précédemment, une simple exposition à l'air, cette exposition étant distinguée d'un barbotage effectué au moyen d'oxygène pur, ne se traduit pas par un tel comportement. Bien que la Figure 3 ne permette pas de discerner la discontinuité mentionnée à 95°C, il est intéressant de noter que dans le cas de solution de décapage lent, étant donné que les deux courbes se coupent, l'oxygène a pour effet de provoquer une augmentation de la vitesse de décapage, aux températures supérieures à celles correspondant aux points d'intersection des courbes, et de provoquer une diminution de cette vitesse de décapage aux températures inférieures aux-dits points d'intersection.

On notera que, lors du décapage de films de silicium polycristallin au moyen de la solution de décapage lent, il se produit une diminution du pouvoir réflecteur du film lorsqu'on emploie de l'eau froide pour mettre fin à l'opération de décapage. Pour éviter cette difficulté, il est nécessaire de plonger initialement le silicium polycristallin décapé dans de l'eau chaude pendant un bref intervalle de temps, de l'ordre, par exemple, de 10 à 20 secondes, puis de le rincer avec de l'eau froide pendant 2 minutes environ. Toutefois, cette diminution du pouvoir réflecteur n'est pas observée dans le cas où la même solution est employée pour décaper du silicium monocristallin, de l'eau froide pouvant alors être employée pour mettre fin à l'opération de décapage.

Une solution de décapage lent peut être obtenue en utilisant de 700 ml à 800 ml environ d'éthylène-diamine, de 110 g à 130 g environ de pyrocatéchine, de 40 ml à 100 ml environ d'eau, et une quantité de diazine ou d'un dérivé de celle-ci correspondant approximativement à l'equivalent molaire de 5 g à 10 g environ de pyrazine/litre d'éthylène-diamine.

Les diazines et leur dérivés qui pourront être utilisés de préférence dans les solutions de décapage de la présente invention comprennent la 1,2 diazine, la 1,4 diazine, les phthalazines, la pyridopyrazine, la phénazine, la 2,5 diméthylpyrazine, la 2,6 dimétylpyrazine, la tétramétylpyrazine et la phénylpyrazine.

Ainsi, deux solutions d'éthylène-diamine, de pyrocatéchine et d'eau catalysées au moyen d'une diazine ou d'un dérivé de celle-ci ont été mises au point, ces solutions étant capables de résister à l'oxygène, ne provoquant pas la formation de résidus, et pouvant être utilisées pour décaper du silicium monocristallin ou polycristallin. L'une de ces solutions, dite de décapage lent, permet d'effectuer un décapage à des températures comprises entre 20°C et 119°C, cependant que l'autre solution, dite de décapage rapide, permet de décaper à des températures comprises entre 100°C et 119°C. La solution préférée de décapage rapide contient 6 g de pyrazine/litre d'éthylène-diamine, 750 ml d'éthylène-diamine, 240 g de pyrocatéchine, 240 ml d'eau et permet d'obtenir une vitesse de décapage maximum d'environ 81 $u$/h. Cette dernière solution est très résistante à l'oxydation ainsi qu'à la formation de résidus à des températures comprises entre 100°C et 119°C. La solution préférée de décapage lent, contenant 6 g de pyramine/litre d'éthylène-diamine, 750 ml d'éthylène-diamine, 120 g de pyrocatéchine et 100 ml d'eau présente une vitesse de décapage sensiblement inférieure (45

$\mu$m/h à 115°C, mais peut être utilisée comme décapant capable de résister à l'oxydation et à la formation de résidus à des températures allant de 119°C à au moins 50°C (4, 5 $\mu$m/h, et convient donc particulièrement bien au décapage de films minces de silicium lorsqu'on désire commander avec précision la vitesse de décapage, ou à l'obtention de rainures de faible épaisseur dans du silicium monocristallin.

Outre les advantages précités, l'invention offre la possibilité d'obtenir des variations importantes de la vitesse de décapage en modifiant la quantité d'eau et/ou de pyrocatéchine contenue dans la solution de décapage, de même que la possibilité d'effectuer le décapage à des températures comprise entre 20°C et 119°C environ, en présence de catalyseurs à base de diazine en quantité correspondant à l'équivalent molaire d'au moins 5 g de pyrazine/litre d'éthylène-diamine.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Solution décapage de films minces en silicium, ne formant pas de résidus et capable de résister à l'oxydation qui comprend: de 700 à 800 ml environ d'éthylène-diamine, de 110 à 130 g environ de pyrocatéchine, de 40 à 100 ml environ d'eau, et une quantité d'une diazine ou d'un dérivé de celle-ci correspondant à l'équivalent molaire de 5 à 10 g de pyrazine/litre d'éthylène-diamine, ladite solution pouvant être employée à des températures comprises entre 20°C et 119°C.

2. Solution de décapage selon la revendication 1, caractérisée en ce que ladite diazine ou le dérivé de celle-ci est constituée par l'un des matériaux suivants: 1,4 diazine, phthalazine, pyridopyrazine, phénazine, 2,5 diméthylpyrazine, 2,6 diméthylpyrazine, tétraméthylpyrazine, et phénylpyrazine.

3. Solution de décapage selon l'une des revendications 1 ou 2 caractérisée en ce qu'elle comprend 750 ml d'éthylène-diamine, 120 g de pyrocatéchine, 100 ml d'eau, et une quantité de diazine correspondant environ à l'équivalent molaire de 6 g de pyrazine/litre d'éthylène-diamine.

4. Solution de décapage selon l'une des revendications 1 ou 3, caractérisée en ce que ladite diazine est de la pyrazine.

5. Procédé de décapage de films minces en silicium, caractérisé en ce qu'il comprend les étapes suivantes:

a) Préparation d'une solution de décapage telle que définie selon l'une qualconque des revendications 1 à 4,

b) application de ladite solution de décapage au silicium à une température comprise entre environ 20°C et 119°C en pendant un intervalle de temps suffisant pour réaliser la configuration de décapage désirée; et

c) interruption du processus de décapage du silicium par ajout d'eau à ladite solution.

6. Procédé selon la revendication 5, caractérisé en ce que le décapage du silicium est effectué à une température comprise entre 50 et 115°C.

7. Procédé selon l'une des revendications 5 ou 6, caractérisé en ce que ledit silicium est polycristallin et en ce que l'opération de décapage est interrompue en immergeant ledit silicium polycristallin décapé dans de l'eau chaude pendant un intervalle de temps compris entre 10 et 20 secondes, puis en le rinçant avec de l'eau froide pendant deux minutes environ.

8. Solution de décapage rapide du silicium ne provoquant pas la formation de résidus et capable de résister à l'oxydation qui comprend: de 700 à 800 ml environ d'éthylène-diamine, de 200 à 250 g environ de pyrocatéchine, de 200 à 250 ml environ d'eau, et une quantité de diazine ou d'un dérivé de celle-ci correspondant à l'équivalent molaire de 5 à 10 g de pyrazine/litre d'éthylène-diamine.

9. Solution de décapage selon la revendication 8, caractérisée en ce qu'elle comprend 750 ml d'éthylène-diamine, 240 g de pyrocatéchine, 240 ml d'eau, et une quantité de diazine correspondant environ à l'équivalent molaire de 6 g de pyrazine-litre d'éthylène-diamine.

10. Solution de décapage selon l'une des revendications 8 ou 9, caractérisée en ce que ladite diazine ou le dérivé de celle-ci est constituée par l'un des matériaux suivants: 1,4 diazine, phthalazine, pyridopyrazine, phénazine, 2,5 diméthylpyrazine, 2,6 diméthylpyrazine, tétraméthylpyrazine, et phénylpyrazine.

11. Procédé de décapage rapide de films de silicium, caractérisé en ce qu'il comprend les étapes suivants: préparation d'une solution de décapage telle que définie selon l'une quelconque des revendications 8 à 10, application de ladite solution de décapage au silicium à une température comprise entre environ 100 et 119°C et pendant un intervalle de temps suffisant pour réaliser la configuration de décapage désirée, et interruption du processus de décapage du silicium par ajout d'eau à ladite solution.

12. Procédé selon la revendication 11 caractérisé en ce que le décapage du silicium est effectué à une température comprise entre 100 et 115°C.

13. Procédé selon la revendication 12, caractérisé en ce que le décapage est effectué à 115°C.

## Claims

1. Residue-free and oxydation-resistant solution for etching thin silicon films, including: from about 700 to 800ml of ethylenediamine, from about 110 to 130g of pyrocatechol, from about 40 to 100ml of water, and a quantity of diazine, or a derivative thereof, corresponding to the molar equivalent of from 5 to 10g of pyrazine/litre of ethylenediamine, said solution being appropriate for use at temperatures ranging from 20°C to 119°C.

2. Etchant solution according to claim 1, characterized in that said diazine, or the derivative thereof, consists of one of the following materials: 1,4 diazine, phthalazine, pyridopyrazine, phenazine, 2,5 dimethylpyrazine, 2,6 dimethylpyrazine, tetramethylpyrazine, and phenylpyrazine.

3. Etchant solution according to claim 1 or 2, characterized in that it includes 750ml of ethylenediamine, 120g of pyrocatechol, 100ml of water, and a quantity of diazine corresponding to about the molar equivalent of 6g of pyrazine/litre of ethylenediamine.

4. Etchant solution according to claim 1 or 3, characterized in that said diazine consists of pyrazine.

5. Method for etching thin silicon films, characterized in that it includes the following steps:

a) preparing an etchant solution such as defined in any one of claims 1 to 4,

b) applying said etchant solution to the silicon at a temperature ranging from about 20°C to 119°C for a duration sufficient to obtain the desired etching pattern, and

c) interrupting the process of etching the silicon by adding water to said solution.

6. Method according to claim 5, characterized in that the silicon is etched at a temperature ranging from 50°C to 115°C.

7. Method according to claim 5 or 6, characterized in that said silicon is polycrystalline and the etching operation is interrupted by dipping said polycrystalline silicon into hot water for a duration comprised between 10 and 20 seconds, and then rinsing it in cold water for about two minutes.

8. Solution for fast silicon etching not causing any residue formation and preventing oxydation, said solution including: from about 700 to 800ml of ethylenediamine, from about 200 to 250g of pyrocatechol, from about 200 to 250ml of water, and a quantity of diazine, or a derivative thereof, corresponding to the molar equivalent of from 5 to 10g of pyrazine/litre of ethylenediamine.

9. Etchant solution according to claim 8, characterized in that it includes 750ml of ethylenediamine, 240g of pyrocatechol, 240ml of water, and a quantity of diazine corresponding to about the molar equivalent of 6g of pyrazine/litre of ethylenediamine.

10. Etchant solution according to claim 8 or 9, characterized in that said diazine, or the derivative thereof, consists of one of the following materials: 1,4 diazine, phthalazine, pyridopyrazine, phenazine, 2,5 dimethylpyrazine, 2,6 dimethylpyrazine, tetramethylpyrazine and phenylpyrazine.

11. Fast silicon film etching method, characterized in that it includes the following steps: preparing an etchant solution such as defined in any one of claims 8 to 10, applying said etchant solution to the silicon at a temperature ranging from about 100°C to 119°C for a duration sufficient to obtain the desired etching pattern, and interrupting the silicon etching process by adding water to said solution.

12. Method according to claim 11, characterized in that silicon etching takes place at a temperature comprised between 100°C and 115°C.

13. Method according to claim 12, characterized in that etching takes place at 115°C.

## Patentansprüche

1. Rückstandsfreie und oxidationsbeständige Lösung zum Ätzen von dünnen Siliciumfilmen, die sich zusammensetzt aus: ungefähr 700 bis 800 ml Äthylendiamin, ungefähr 110 bis 130 g Brenzcatechin, ungefähr 40 bis 100 ml Wasser und einem Diazin oder dem Diazinderivat in einer Menge pro Liter Äthylendiamin, welche in Mol ausgedrückt gleich der Molmenge von 5 bis 10 g Pyrazin ist, wobei die Lösung bei Temperaturen zwischen 20°C und 119°C verwendet werden kann.

2. Ätzlösung nach Anspruch 1, dadurch gekennzeichnet, daß das Diazin oder das Derivat davon, aus einem der folgenden Materialien besteht: 1,4 Diazin, Phthalazin, Pyridopyrazin, Phenazin, 2,5 Dimethylpyrazin, 2,6 Dimethylpyrazin, Tetramethylpyrazin und Phenylpyrazin.

3. Ätzlösung nach Anspruch 1 oder 2, dadurch gekennzeichnet, daß sie 750 ml Äthylendiamin, 120 g Brenzcatechin, 100 ml Wasser und ungefähr eine Menge Diazin/Liter Äthylendiamin enthält, welche in Mol ausgedrückt gleich der Molmenge von 6 g Pyrazin ist.

4. Ätzlösung nach Anspruch 1 oder 3, dadurch gekennzeichnet, daß das Diazin aus Pyrazin besteht.

5. Verfahren zum Ätzen von dünnen Siliciumfilmen, dadurch gekennzeichnet, daß es folgende Schritte einschließt:

a) Vorbereiten einer Ätzlösung, wie sie in einem der Ansprüche 1 bis 4 definiert ist,

b) Anwenden dieser Ätzlösung auf das Silicium bei einer Temperatur von 20°C bis 119°C während einer genügend langen Zeit, um das gewünschte Ätzmuster zu erhalten und

c) Unterbrechen des Siliciumätzverfahrens, indem der Lösung Wasser zugefügt wird.

6. Verfahren nach Anspruch 5, dadurch gekennzeichnet, daß das Siliciumätzen bei einer Temperatur von 50°C bis 115°C erfolgt.

7. Verfahren nach Anspruch 5 oder 6, dadurch gekennzeichnet, daß das Silicium polykristallin ist, und daß der Ätzprozeß unterbrochen wird, indem das geätzte, polykristalline Silicium während einer Zeitspanne von 10 bis 20 Sekunden in heißes Wasser getaucht und anschließend ungefähr zwei Minuten lang in kaltem Wasser gespült wird.

8. Lösung zum Schnellätzen von Silicium, welche nicht die Bildung von Rückständen verursacht und resistent gegen Oxidation ist, bestehend aus: ungefähr 700 bis 800 ml Äthylenediamin, ungefähr 200 bis 250 g Brenzcatechin, ungefähr 200 bis 250 ml Wasser und Diazin oder einem Diazinderivat in einer Menge pro Liter Äthylendiamin, welche in Mol ausgedrückt gleich der Menge von 5 bis 10 g Pyrazin ist.

9. Ätzlösung nach Anspruch 8, dadurch gekennzeichnet, daß sie 750 ml Äthylendiamin, 240 g Brenzcatechin, 240 ml Wasser und Diazin in einer Menge Liter Äthylenediamin enthält, welche in Mol ausgedrückt gleich der Molmenge von 6 g Pyrazin ist.

10. Ätzlösung nach Anspruch 8 oder 9, dadurch gekennzeichnet, daß das Diazin oder ein Derivat davon aus einem der folgenden Materialien besteht: 1,4 Diazin, Phthalazin, Pyridopyrazin, Phenazin, 2,5 Dimethylpyrazin, 2,6 Dimethylpyrazin, Tetramethylpyrazin und Phenylpyrazin.

11. Verfahren zum Schnellätzen von dünnen Siliciumfilmen, dadurch gekennzeichnet, daß es folgende Verfahrensschritte einschließt: Vorbereiten einen Ätzlösung, wie sie in einem der Ansprüche 8 bis 10 definiert ist, Anwenden der Ätzlösung auf das Silicium bei einer Temperatur von 100°C bis 119°C während einer genügend langen Zeitspanne, um das gewünschte Ätzmuster zu erhalten, und Unterbrechen des Siliciumätzverfahrens, indem der Lösung Wasser beigefügt wird.

12. Verfahren nach Anspruch 11, dadurch gekennzeichnet, daß das Siliciumätzen bei einer Temperatur von 100°C bis 115°C stattfindet.

13. Verfahren nach Anspruch 12, dadurch gekennzeichnet, daß das Ätzen bei einer Temperatur von 115°C stattfindet.

# FIG. 1

## FIG. 2

TEMPERATURE (°C)

1 / T  °K x 10³

## FIG. 3

TEMPERATURE (°C)

DECAPAGE LENT

SANS EXPOSITION
A L'OXYGENE
8,4Kcal/mole

EXPOSITION
DE 4H A L'OXYGENE
11Kcal/mole

VITESSE DE DECAPAGE DU si- $\mu m/h$.

$1/T°K \times 10^3$

3